# EUROPEAN PATENT APPLICATION

(11) **EP 1 763 091 A2**
(43) Date of publication of application: **14.03.2007**
(21) Application number: 06119710.9
(22) Date of filing: 29.08.2006
(51) Int. Cl.: H01L 39/24

(54) **Method of manufacturing for Nb3Sn superconducting wire rod by means of powder method and precursor therefor**

(30) Priority: 13.09.2005 JP 2005265437
(71) Applicant: Kabushiki Kaisha Kobe Seiko Sho (Kobe Steel, Ltd.), Kobe-shi, Hyogo 651-8585 (JP)
(72) Inventor: Miyazaki, Takayoshi, Kobe-shi Hyogo 651-2271 (JP); Zaitsu, Kyoji, Kobe-shi Hyogo 651-2271 (JP); Miyatake, Takayuki, Kobe-shi Hyogo 651-2271 (JP); Kato, Hiroyuki, Kobe-shi Hyogo 651-2271 (JP)
(74) Representative: TBK-Patent

(57) **Abstract**

In a precursor for producing a Nb₃Sn superconducting wire rod in which a plurality of composite members each prepared by filling a base powder containing at least Sn in a sheath composed of Nb or a Nb alloy are embedded in a copper matrix part, a copper ratio given as the ratio of the cross-sectional area of a copper part to the cross-sectional area of a non-copper part (cross-sectional area of copper part/cross-sectional area of non-copper part) in a cross-section in a direction perpendicular to the longitudinal direction is in the range of 0.3 to 1.8.

## Description

### BACKGROUND OF THE INVENTION

### 1. Field of the Invention

The present invention relates to a precursor (precursor for producing a superconducting wire rod) for producing a Nb₃Sn superconducting wire rod in which a high critical current density can be obtained with a satisfactory processability by means of a powder method, a useful method of producing a Nb₃Sn superconducting wire rod using the precursor, and the like. In particular, the present invention relates to a method of producing a Nb₃Sn superconducting wire rod useful for a material of a superconducting magnet for generating a magnetic field that is used in a nuclear magnetic resonance (NMR) analyzer, a nuclear fusion device, an accelerator, a power storage device, a study of physical properties, or the like, and a precursor therefor.

### 2. Description of the Related Art

In the field in which superconducting wire rods have been in practical use, regarding a superconducting magnet used in a high-resolution NMR analyzer or the like, an increase in magnetic field generated can increase the resolution. Therefore, recently, the magnetic field generated by a superconducting magnet has been increasing.

As a superconducting wire rod used for a superconducting magnet for high-magnetic-field generation, a Nb₃Sn wire rod has been practically used. A bronze method is mainly employed for producing this Nb₃Sn superconducting wire rod. In the bronze method, a plurality of Nb-based alloy core members are embedded in a Cu-Sn-based alloy (bronze) matrix, the Nb-based core members are subjected to wire drawing to form filaments, a plurality of the filaments are bundled to form a wire rod group, the wire rod group is embedded in copper (stabilizing copper) for stabilizing, and wire drawing is performed. The wire rod group is subjected to heat treatment (diffusion heat treatment) in the range of 600°C to 800°C to form a Nb₃Sn compound phase (Nb₃Sn superconducting phase) at the interface between the Nb-based filaments and the matrix. However, in this method, the concentration of Sn that is dissolved in the bronze in the form of a solid solution is limited (15.8 mass percent or less), the thickness of the formed Nb₃Sn layer is small, and the crystallinity is degraded, resulting in a problem of an unsatisfactory high-magnetic-field property.

In addition to the bronze method, a powder method is also a known method of producing the Nb₃Sn superconducting wire rod. For example, according to a method described in Japanese Unexamined Patent Application Publication No. 11-250749, Sn and at least one metal (alloy element) selected from the group consisting of Ti, Zr, Hf, V, and Ta are subjected to melt diffusion reaction at a high temperature to form an alloy or an intermetallic compound thereof, the product is then pulverized to prepare a Sn compound base powder, the powder is filled as a core member (powder core part 2 described below) in a sheath composed of Nb or a Nb-based alloy, and the diameter is reduced followed by heat treatment (diffusion heat treatment). According to the description, since this method can produce a thick and a high-quality Nb₃Sn superconducting phase compared with the bronze method, a superconducting wire rod having an excellent high-magnetic-field property can be obtained.

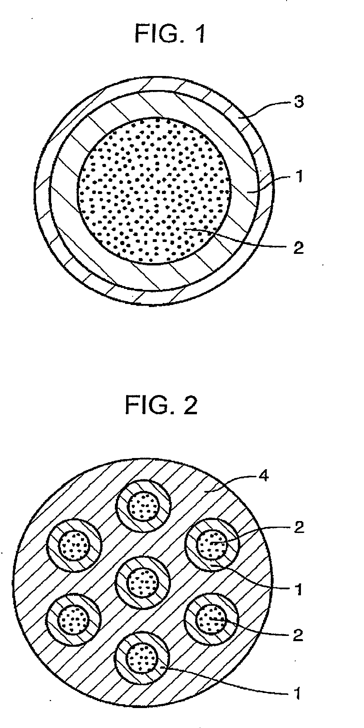

Fig. 1 is a cross-sectional view schematically showing the structure of a precursor (single-core wire) used in producing a Nb₃Sn superconducting wire rod by means of a powder method. As shown in Fig. 1, the precursor includes a sheath (tubular component) 1 composed of Nb or a Nb-based alloy, a powder core part 2 in which a base powder is filled, and stabilizing copper (stabilizing Cu) 3. In order to perform the powder method, a base powder containing at least Sn is filled in the powder core part 2 of the sheath 1, and a diameter-reducing process such as extrusion and wire drawing is then performed to form a primary composite wire rod. Subsequently, the wire rod is wound around a magnet or the like followed by heat treatment. Thus, a Nb₃Sn superconducting phase is formed from the inner surface of the sheath. Fig. 1 shows a single-core wire rod as a representative example. However, in practical use, a plurality of single-core wire rods are disposed in a Cu pipe (Cu billet) and are generally used in the form of a multi-core precursor as shown in Fig. 2. In the structure of the multi-core precursor, as shown in Fig. 2, the stabilizing Cu 3 is integrated with the Cu billet to form a copper matrix part 4. The multi-core precursor shown in Fig. 2 is subjected to a diameter-reducing process such as extrusion and wire drawing, and then heat-treated to form a Nb₃Sn superconducting wire rod as in the single-core wire.

In order to improve the characteristics of the superconducting wire rod produced by means of the powder method, various techniques have been proposed to date. For example, according to Japanese Unexamined Patent Application Publication No. 2004-111111, when a base powder is filled in the sheath (reference numeral 1 in Fig. 1) composed of Nb or a Nb-based alloy, a core member composed of Nb or a Nb-based alloy is inserted into the sheath. Thereby, this method provides a superconducting wire rod with an excellent superconducting property in which the superconducting property is not degraded even when a deformation is introduced.

According to a technique proposed in Japanese Unexamined Patent Application Publication No. 2003-86041, a mixture of a powder mainly containing Nb₃Sn, a Sn powder, and a Cu powder is used as a base powder in producing a superconducting wire rod by means of the powder method, thereby improving the superconducting property.

The precursor used in producing a superconducting wire rod by means of the powder method includes Nb or a Nb-based alloy (sheath), a powder mainly containing Sn (powder core part), a copper matrix part, and the like. The difference in deformation resistance between these materials is significantly large. Therefore, it is very difficult to carry out processing uniformly on the precursor composed of these materials, and thus the sheath may be broken or breaking of the wire rod may occur in the course of processing.

According to a technique proposed in, for example, Japanese Unexamined Patent Application Publication No. 2005-93235, in order to realize uniform wire drawing, an interlayer composed of at least one metal selected from the group consisting of Ta, Ti, W, Mo, and V or an alloy thereof is provided on the outer periphery of a sheath composed of Nb or a Nb-based alloy.

The techniques described in Japanese Unexamined Patent Application Publication Nos. 11-250749, 2004-111111, and 2003-86041 are useful techniques from the viewpoint of improving the superconducting property. However, the precursor has a complex structure, and accordingly, the processability may be degraded. In order to maintain a satisfactory processability, the processing conditions must be finely adjusted. In some cases, breaking occurs during wire drawing.

On the other hand, in the technique described in Japanese Unexamined Patent Application Publication No. 2005-93235, although the processability is improved, the superconducting property may be degraded because the superconducting part is decreased in area.

Accordingly, it is desirable to further improve the superconducting property of a superconducting wire rod produced by means of a powder method, and to realize a precursor for producing a superconducting wire rod having a satisfactory processability during wire drawing or the like.

### SUMMARY OF THE INVENTION

The present invention has been made under this situation. It is an object of the present invention to provide a precursor for producing a Nb₃Sn superconducting wire rod wherein when produced by means of a powder method, an excellent superconducting property is exhibited, and a problem of processability during extrusion, wire drawing, and the like does not occur, and to provide such a superconducting wire rod.

The above object can be achieved by a precursor for producing a Nb₃Sn superconducting wire rod by means of a powder method of the present invention. According to an essence of the present invention, in the precursor for producing a Nb₃Sn superconducting wire rod in which a plurality of composite members each prepared by filling a base powder containing at least Sn in a sheath composed of Nb or a Nb alloy are embedded in a copper matrix part by means of a powder method, a copper ratio A given as the ratio of the cross-sectional area of a copper part to the cross-sectional area of a non-copper part (cross-sectional area of copper part/cross-sectional area of non-copper part) in a cross-section in a direction perpendicular to the longitudinal direction is in the range of 0.3 to 1.8. In the precursor for producing a Nb₃Sn superconducting wire rod, the copper ratio is preferably in the range of 0.4 to 0.8.

The above object can also be achieved by a Nb₃Sn superconducting wire rod of the present invention. According to an essence of the present invention, the Nb₃Sn superconducting wire rod is produced by the steps of filling a base powder containing at least Sn in a sheath composed of Nb or a Nb alloy, covering the outer periphery of the sheath with stabilizing copper to form a single-core wire, performing a process for reducing the diameter of the single-core wire to form a primary composite wire rod, inserting a plurality of the primary composite wire rods into a copper billet to form a multi-core precursor in which a copper ratio A given as the ratio of the cross-sectional area of a copper part to the cross-sectional area of a non-copper part (cross-sectional area of copper part/cross-sectional area of non-copper part) in a cross-section in a direction perpendicular to the longitudinal direction is in the range of 0.3 to 1.8, performing a process for reducing the diameter of the multi-core precursor, and heat-treating the multi-core precursor to form a Nb₃Sn superconducting layer from the inner surface side of the sheath. In the Nb₃Sn superconducting wire rod, a copper ratio given as the ratio of the cross-sectional area of the stabilizing copper to the cross-sectional area of the non-copper part (cross-sectional area of stabilizing copper/cross-sectional area of non-copper part) in the single-core wire is preferably in the range of 0.1 to 0.45.

According to the present invention, in a precursor used in producing a superconducting wire rod, a copper ratio specified as the ratio of the cross-sectional area of the copper part to the cross-sectional area of the non-copper part is set to an appropriate range. Accordingly, a Nb₃Sn superconducting wire rod that exhibits an excellent superconducting property can be produced without causing a problem of breaking during a process of reducing the diameter of the wire rod or the like.

### BRIEF DESCRIPTION OF THE DRAWINGS

Fig. 1 is a cross-sectional view schematically showing the structure of a precursor (single-core wire) used in producing a Nb₃Sn superconducting wire rod by means of a powder method;
Fig. 2 is a cross-sectional view schematically showing the structure of a multi-core precursor used in producing a Nb₃Sn superconducting wire rod by means of a powder method; and
Fig. 3 is a graph showing the relationship between the copper ratio A and the critical current density Jc in a multi-core precursor.

### DESCRIPTION OF THE PREFERRED EMBODIMENTS

The present inventors have conducted extensive studies on methods of producing a Nb₃Sn superconducting wire rod that can be formed by satisfactory extrusion, wire drawing, and the like and that exhibits a satisfactory superconducting property. As a result, the present inventors have found that, in a precursor used in producing a Nb₃Sn superconducting wire rod by means of a powder method, the above object can be excellently achieved by exactly controlling the copper ratio A given as the ratio of the cross-sectional area of a copper part to the cross-sectional area of a non-copper part (cross-sectional area of copper part/cross-sectional area of non-copper part) in a cross-section in a direction perpendicular to the axial center so as to be in the range of 0.3 to 1.8, and have completed the present invention.

In the precursor used in producing a superconducting wire rod by means of a powder method, as described above, the difference in deformation resistance between materials thereof is fundamentally significantly large. Therefore, it has been believed that the amount of copper, which is a material constituting the precursor, does not significantly affect the wire drawing processability and the superconducting property. However, according to a study conducted by the present inventors, it has become evident that both the processability and the superconducting property can be maintained in an excellent state by exactly specifying the copper ratio A (cross-sectional area of copper part/cross-sectional area of non-copper part) calculated by dividing an area of copper constituting a matrix by an area of a non-copper part in a multi-core wire rod having a specific cross-sectional structure.

According to an essence of a precursor of the present invention, in the structure of a multi-core wire rod shown in Fig. 2, a copper ratio (hereinafter referred to as "copper ratio A") calculated by dividing the cross-sectional area of a copper part (i.e., the copper matrix part 4) by the cross-sectional area of a non-copper part (i.e., the core part 2 and the sheath 1) is controlled in the range of 0.3 to 1.8. The reason that the copper ratio A is specified in this range is as follows.

When the copper ratio A is less than 0.3, as described in examples below, the processability is extremely degraded and a quench (a sudden transition from the superconducting state to the normal conduction state) easily occurs in some cases, thereby impairing the stability of the superconducting property. On the other hand, when the copper ratio A exceeds 1.8, for example, the area of the superconducting part is decreased, or the thermal shrinkage strain applied to Nb is increased, thereby decreasing the critical current density Jc. In order to realize a more stable processability and a satisfactory superconducting property (in particular, critical current density Jc), the copper ratio is preferably in the range of 0.4 to 0.8.

The above precursor is subjected to a diameter-reducing process and subsequent heat treatment to form a Nb₃Sn superconducting layer from the inner surface of the sheath. Thus, a satisfactory superconducting property can also be exhibited while a satisfactory processability is maintained. When a superconducting wire rod is produced using such a multi-core precursor, fundamentally, it is sufficient that the copper ratio A is within the above range at a stage of the final multi-core wire rod. However, the processability in the single-core wire shown in Fig. 1 is also preferably considered in view of maintaining a satisfactory processability.

That is, the appropriate control of a copper ratio (stabilizing copper/non-copper part, hereinafter referred to as "copper ratio B") at the stage of the single-core wire (at the stage shown in Fig. 1) is also a preferred requirement in view of production. From this viewpoint, the copper ratio B at the stage of the single-core wire, which is a material constituting the multi-core wire, is preferably set in the range of 0.1 to 0.45. When the copper ratio B is less than 0.1, the Cu outer cover (stabilizing copper 3) is broken, resulting in a difficulty of uniform processing. When the copper ratio B exceeds 0.45, the area of the nonsuperconducting part is increased when forming a multi-core wire or it is difficult to form a multi-core wire while the copper ratio A is controlled to be in the appropriate range. In any case, the critical current density Jc is decreased.

In any of the above structures, considering the conductivity and the processability, preferably, copper used as the copper matrix (reference numeral 4 in Fig. 2) (i.e., the stabilizing Cu and the copper billet) in the present invention fundamentally contains no alloy element, and impurities therein are preferably decreased as much as possible. In the case where copper contains a large amount of these elements or impurities, even when the copper ratios A and B are in appropriate ranges, the object of the present invention cannot be achieved. From this viewpoint, oxygen-free copper in which the oxygen content is reduced to 60 ppm or less is most suitably used as the copper matrix used in the present invention.

The precursor used in the present invention fundamentally has the cross-sectional structures shown in Figs. 1 and 2. Alternatively, for example, from the viewpoint that the degradation of the superconducting property caused by introducing a deformation is prevented, a core member composed of Nb or a Nb-based alloy may be inserted into the powder core part 2. From the viewpoint of realizing a uniform process, an interlayer composed of at least one metal selected from the group consisting of Ta, Ti, W, Mo, and V or an alloy thereof may be provided on the outer periphery of the sheath. However, in order to simplify the structure of the precursor as much as possible to maintain the processability, the structures shown in Figs. 1 and 2 are preferably used.

When a base powder serving as a core material is filled in the above sheath, the base powder is compressed by a uniaxial pressing to increase the filling ratio of the base powder in the powder core part 2. However, voids may inevitably remain. From the viewpoint of eliminating these voids, it is also effective that the base powder may be subjected to an isostatic powder compaction process such as a cold isostatic pressing method (CIP method) in advance to form a molded body (compact). By performing such a powder compaction process, the filling ratio of the base powder in the sheath can be increased to 90% or more. When the CIP of the base powder is performed, the base powder is filled in a rubber die and is then subjected to the CIP process. The molded body prepared as described above can be machined, and thus the accuracy of the billet assembly can be increased accordingly.

The base powder used in the present invention contains at least Sn. Specifically, an example of the base powder contains Sn and at least one metal selected from the group consisting of Ti, Zr, Hf, V, Ta, and Cu as components. The base powder may be used in the form of an alloy powder, an intermetallic compound powder, or a mixed powder. Alternatively, an alloy material containing these components may also be used. Among the components contained in the core material, Sn is reacted with Nb or a Nb-based alloy disposed therearound to form a Nb₃Sn layer. Components such as Ti, Zr, Hf, V, and Ta have an effect of promoting the formation of the Nb₃Sn layer and an effect of improving the Jc at 20 T or higher by forming a solid solution in the Nb₃Sn layer. Copper is added according to need because it has an effect of decreasing the heat treatment temperature (for example, in the range of about 650°C to 750°C).

A sheath material used in the present invention is composed of Nb or a Nb-based alloy (for example, an alloy containing Nb and about 0.1% to 10% of elements such as Ti, Zr, Hf, V, and Ta). Although this material itself does not significantly affect the processability, the material must have a certain thickness (in the range of 10 to 100 µm at the stage of the final drawing) to the extent that cracks are not generated on a part of the sheath material during processing. As long as these requirements are satisfied, the thickness of the tubular material used is preferably thin as much as possible so that a large amount of the base powder can be filled in the core part.

The present invention will now be described more specifically by way of examples. It should be understood that the present invention is not limited to the following examples, and modifications can be added within the scope that can follow the essences described above and below to embody the present invention. All these modifications are also included in the technical scope of the present invention.

### EXAMPLES

A Ta powder and a Sn powder were mixed so that the molar ratio was 6:5 (Ta:Sn). The mixed powder was heat-treated at 950°C for 10 hours in vacuum and was then pulverized. Five mass percent of a copper powder was mixed with the resulting powder, and cold isostatic pressing (CIP) was then performed to prepare compacts each having dimensions of 35 mm (diameter) x 200 mm. The compacts were cut so as to have final dimensions of 30 mm (diameter) x 180 mm.

Each of the compacts was inserted into a Nb-7.5 mass percent Ta cylindrical component (sheath material) with an outer diameter (outer diameter b) shown in Table 1 below and an inner diameter of 30 mm. The resulting compact was further inserted into a Cu extrusion billet (corresponding to the stabilizing Cu 3) with an outer diameter (outer diameter a) shown in Table 1. The billet was again extruded, and was subjected to wire drawing to prepare a single-core wire.

The billet was extruded, and was then subjected to wire drawing to form a hexagonal member with an opposite side distance of 4.3 mm. The hexagonal members were inserted into a Cu billet with an outer diameter (outer diameter c) shown in Table 1 and an inner diameter of 37 mm to form a multi-core precursor. The precursor was extruded again and was subjected to wire drawing so as to have a final diameter of 1.5 mm.

The precursor after wire drawing was subjected to a heat treatment (diffusion heat treatment) at 650°C for 200 hours. Subsequently, the critical current Ic was measured in an external magnetic field of 18 T using the resulting superconducting magnet. The critical current density (overall critical current density Jc) was determined by dividing the measured critical current Ic by the cross-sectional area of the wire rod. The results are shown in Table 1 together with dimensions (outer diameters a, b, and c; inner diameter d; and copper ratios A and B) of the single-core wires and the multi-core wires. The acceptance criterion of the critical current density is 100 A/mm².

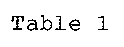

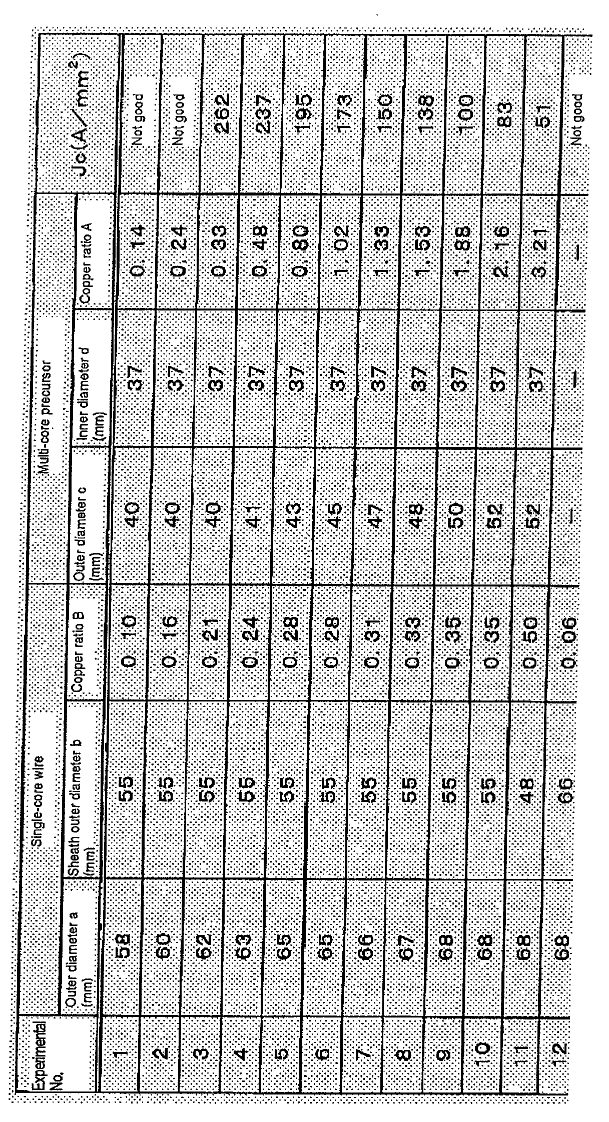

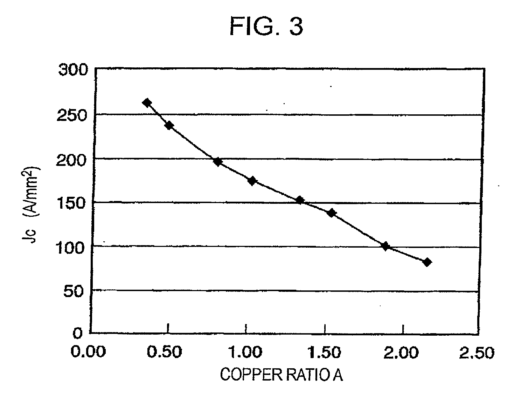

In samples of experimental Nos. 1 and 2 in Table 1, breakings were generated on the copper outer cover (Cu billet) during wire drawing for forming the multi-core wire rod. In the sample of experimental No. 12, breakings were generated on the copper outer cover (Cu billet) during wire drawing for forming the single-core wire. Therefore, the critical current densities of these samples were not measured (each represented by "Not good"). The relationship between the copper ratio A and the critical current density Jc in the multi-core precursors is shown in Fig. 3 on the basis of these results.

As is apparent from the results, by controlling the copper ratio A in the multi-core precursor for producing a superconducting wire rod to be in the range of 0.3 to 1.8, high critical current densities of 100 A/mm² or more could be obtained. In particular, in samples having a copper ratio A in the range of 0.4 to 0.8, critical current densities of 200 A/mm² or more could be achieved and a satisfactory processability could also be achieved. The results also showed that, in the single-core wire, a satisfactory processability could be maintained by appropriately setting the copper ratio B.

In a precursor for producing a Nb₃Sn superconducting wire rod in which a plurality of composite members each prepared by filling a base powder containing at least Sn in a sheath composed of Nb or a Nb alloy are embedded in a copper matrix part, a copper ratio given as the ratio of the cross-sectional area of a copper part to the cross-sectional area of a non-copper part (cross-sectional area of copper part/cross-sectional area of non-copper part) in a cross-section in a direction perpendicular to the longitudinal direction is in the range of 0.3 to 1.8.

## Claims

1. A precursor for producing a Nb₃Sn superconducting wire rod in which a plurality of composite members each prepared by filling a base powder containing at least Sn in a sheath composed of Nb or a Nb alloy are embedded in a copper matrix part by means of a powder method,
wherein a copper ratio A given as the ratio of the cross-sectional area of a copper part to the cross-sectional area of a non-copper part (cross-sectional area of copper part/cross-sectional area of non-copper part) in a cross-section in a direction perpendicular to the longitudinal direction is in the range of 0.3 to 1.8.

2. The precursor for producing a Nb₃Sn superconducting wire rod by means of a powder method according to claim 1, wherein the copper ratio A is in the range of 0.4 to 0.8.

3. A Nb₃Sn superconducting wire rod by means of a powder method, the superconducting wire rod being produced by the steps of:
filling a base powder containing at least Sn in a sheath composed of Nb or a Nb alloy;
covering the outer periphery of the sheath with stabilizing copper to form a single-core wire;
performing a process for reducing the diameter of the single-core wire to form a primary composite wire rod;
inserting a plurality of the primary composite wire rods into a copper billet to form a multi-core precursor in which a copper ratio A given as the ratio of the cross-sectional area of a copper part to the cross-sectional area of a non-copper part (cross-sectional area of copper part/cross-sectional area of non-copper part) in a cross-section in a direction perpendicular to the longitudinal direction is in the range of 0.3 to 1.8;
performing a process for reducing the diameter of the multi-core precursor; and
heat-treating the multi-core precursor to form a Nb₃Sn superconducting layer from the inner surface side of the sheath.

4. The Nb₃Sn superconducting wire rod by means of a powder method according to claim 3, wherein a copper ratio B given as the ratio of the cross-sectional area of the stabilizing copper to the cross-sectional area of the non-copper part (cross-sectional area of stabilizing copper/cross-sectional area of non-copper part) in the single-core wire is in the range of 0.1 to 0.45.
